# EUROPÄISCHE PATENTANMELDUNG

(11) **EP 1 865 750 A2**
(43) Veröffentlichungstag der Anmeldung: **12.12.2007**
(21) Anmeldenummer: 07108933.8
(22) Anmeldetag: 25.05.2007
(51) Int. Cl.: H04R 25/00

(54) **SMD-Batteriekontaktmodul**

(30) Priorität: 08.06.2006 DE 102006026753
(71) Anmelder: Siemens Audiologische Technik GmbH, 91058 Erlangen (DE)
(72) Erfinder: Ong, Vincent, 530441 Singapore (SG); Heerlein, Markus, 288408 Singapore (SG); Kasztelan, Thomas, 91058 Erlangen (DE)
(74) Vertreter: Berg, Peter

(57) **Zusammenfassung**

Die Fertigung von Hörvorrichtungen und insbesondere von Hörgeräten soll vereinfacht werden. Hierzu wird ein Batteriekontaktmodul (10) mit einer elektrischen Kontakteinrichtung (2, 3, 4, 5) und einem Kunststoffrahmen (1) vorgeschlagen, an/in dem die Kontakteinrichtung befestigt ist. Dabei ist das Batteriekontaktmodul als SMD-Bauteil ausgebildet und die Kontakteinrichtung weist entsprechende Anschlüsse (4, 5) für eine Oberflächenmontage auf einer Leiterplatte auf. In vorteilhafter Weise kann dadurch eine Verstärkerleiterplatte automatisch mit dem Batteriekontaktmodul bestückt und verlötet werden.

## Beschreibung

Die vorliegende Erfindung betrifft ein Batteriekontaktmodul für eine Hörvorrichtung mit einer elektrischen Kontakteinrichtung und einem Kunststoffrahmen, an/in dem die Kontakteinrichtung befestigt ist. Insbesondere betrifft die vorliegende Erfindung ein Batteriekontaktmodul für ein Hörgerät. Ein derartiges Batteriekontaktmodul kann aber auch für Headsets, Kopfhörer und dergleichen Verwendung finden.

Die Stromversorgung in einem Hörgerät erfolgt typischerweise über eine Batterie. Diese wird in der Regel über eine Kontakteinrichtung mit einer Leiterplatte verbunden. Die Kontakteinrichtung besteht dabei aus Batteriekontakten, die von Hand in einem Rahmen platziert werden. Der Fertigungsaufwand ist entsprechend hoch.

Darüber hinaus werden die Batteriekontakte in der Regel mithilfe so genannter Durchgangslöcher auf der Leiterplatte befestigt. In diesem Fall ist es nicht mehr oder nur noch eingeschränkt möglich, die Leiterplatte zweiseitig zu bestücken.

Aus der Patentschrift DE 102 14 542 C1 ist eine Kontaktvorrichtung für eine Batterie zum Einbau in ein In-dem-Ohr-Hörgerät bekannt. Die Kontaktvorrichtung besteht aus einem Spritzgusskörper, in den mit der so genannten Insert-Mold-Technologie Metallkontaktfedern eingebracht sind. Darüber hinaus werden Verdrahtungselemente als Leiterbahnen auf den Spritzgusskörper aufgebracht.

Die weitere Druckschrift DE 102 61 733 B4 zeigt einen Steckverbinder mit gerollter Hülse. Speziell kann es sich um einen in SMD-Bauweise ausgeführten Batteriekontaktsteckverbinder handeln. Das Gehäuse des Steckverbinders ist aus LCP-Kunststoff hergestellt.

Die Aufgabe der vorliegenden Erfindung besteht darin, die Fertigung einer Hörvorrichtung zu vereinfachen.

Erfindungsgemäß wird diese Aufgabe gelöst durch ein Batteriekontaktmodul für eine Hörvorrichtung mit einer elektrischen Kontakteinrichtung und einem Kunststoffrahmen, an/in dem die Kontakteinrichtung befestigt ist, wobei das Batteriekontaktmodul als SMD-Bauteil ausgebildet ist und die Kontakteinrichtung entsprechende Anschlüsse für eine Oberflächenmontage aufweist. Somit kann auf eine spezielle Fertigungsvorrichtung für die einzelnen Batteriekontakte zur Vormontage eines Verstärkers verzichtet werden. Des Weiteren weist der Kunststoffrahmen eine Bohrung oder ein vorspringendes Montageelement auf, mit der/dem das Batteriekontaktmodul an einem Gehäuse der Hörvorrichtung befestigbar ist. Ist das Batteriekontaktmodul dann auf eine Leiterplatte aufgelötet, lässt sich über diese Befestigungsmöglichkeit die gesamte Leiterplatte an dem Gehäuse befestigen. Außerdem ist mit dieser Befestigung ein eindeutiger Bezug der Leiterplatte zu Bedienelementen gegeben.

Ferner besitzt der Kunststoffrahmen mindestens einen Führungsstift oder eine Führungsbohrung, um das Batteriekontaktmodul auf einer Leiterplatte bei der Fertigung zu fixieren. Diese Führungselemente dienen insbesondere dazu, dass das Batteriekontaktmodul beim Löten nicht seine Position verändert. Dadurch kann auf spezielle Halterahmen für die Vormontage verzichtet werden.

Entsprechend der Erfindung ist es somit möglich, auch ein Batteriekontaktmodul maschinell auf eine Leiterplatte aufzubringen. Dadurch lassen sich die Fertigungskosten für die Hörvorrichtung und insbesondere für ein Hörgerät weiter reduzieren.

Vorzugsweise ist das Material des Kunststoffrahmens zumindest an seiner Oberfläche nicht hygroskopisch. Es ist also vorteilhaft, wenn das Material Wasserdampf bzw. Wasser nicht adsorbiert oder absorbiert. Insbesondere ist es günstig, wenn das Material nicht porös ist. Hierdurch kann vermieden werden, dass das Batteriekontaktmodul, wenn es beispielsweise beim Löten hohen Temperaturen ausgesetzt wird, beschädigt wird.

Besonders vorteilhaft ist darüber hinaus, wenn der Kunststoffrahmen derart temperaturbeständig ist, dass er ohne Verformung für mindestens zwei Sekunden einer Temperatur von mindestens 250 °C ausgesetzt werden kann. Insbesondere sollte der Kunststoffrahmen drei Sekunden lang einer Temperatur von 260 °C ausgesetzt werden können. Dadurch kann das SMD-Batteriekontaktmodul einen Reflow-Lötprozess unbeschadet überstehen. Ein hierfür besonders geeigneter Kunststoff wäre ein Flüssigkristallpolymer.

Die Kontakteinrichtung des erfindungsgemäßen Batteriekontaktmoduls kann in den Kunststoffrahmen eingespritzt sein. Somit lässt sich auch der Herstellungsaufwand des Batteriekontaktmoduls reduzieren.

Die Kontakteinrichtung kann zwei Metallfedern aus nicht rostendem Stahl aufweisen. Hierdurch kann stets ein ausreichender Kontaktdruck auf die Batteriekontakte ausgeübt werden.

Die vorliegende Erfindung wird nun anhand der beigefügten Zeichnungen näher erläutert, in denen zeigen:
- FIG 1: ein erfindungsgemäßes Batteriekontaktmodul in einer Vorderseitenansicht;
- FIG 2: das Batteriekontaktmodul von FIG 1 in der Rückseitenansicht;
- FIG 3: das auf eine SMD-Leiterplatte montierte Batteriekontaktmodul mit Batterie;
- FIG 4: die bestückte Leiterplatte von FIG 3 in der Seitenansicht; und
- FIG 5: die bestückte Leiterplatte von FIG 3 in der Draufsicht.

Das nachfolgend näher geschilderte Ausführungsbeispiel stellt eine bevorzugte Ausführungsform der vorliegenden Erfindung dar.

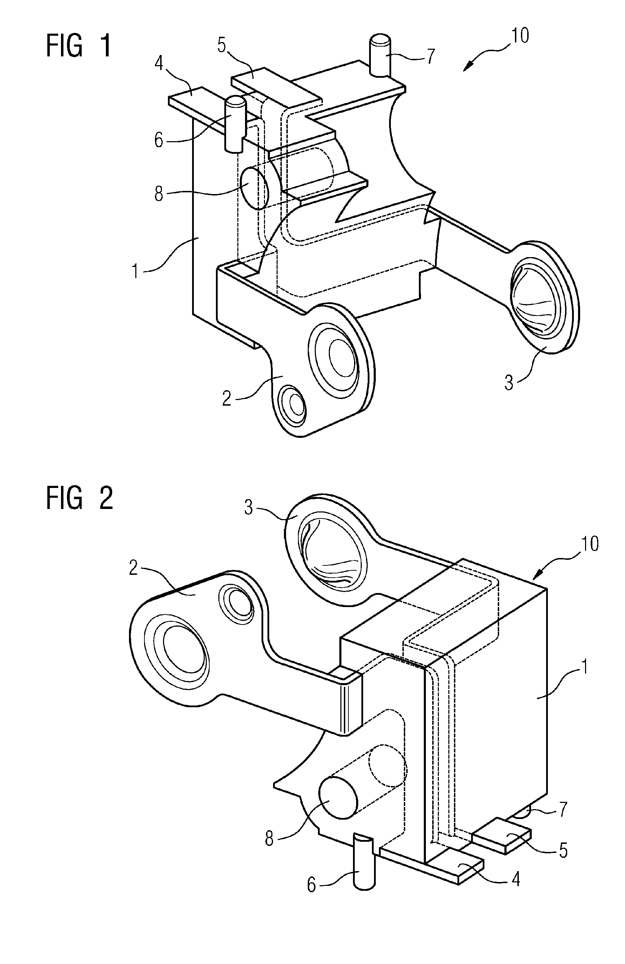

Das in FIG 1 wiedergegebene erfindungsgemäße Batteriekontaktmodul 10 besitzt einen Rahmen 1, der aus einem Kunststoff gespritzt ist. In den Rahmen 1 sind zwei Kontaktfedern 2 und 3 aus rostfreiem Stahl eingespritzt. Diese Kontaktfedern 2 und 3 dienen zum Kontaktieren des Pluspols und des Minuspols einer Batterie. An ihrem jeweils anderen Ende ragen sie aus dem Kunststoffrahmen 1 und bilden dort jeweils ein so genanntes SMD-Kontaktpad 4, 5. Diese Kontaktpads 4, 5 sind in einem Reflow-Prozess auf einer Leiterplatte auflötbar.

An den Rahmen sind weiterhin zwei Stifte 6, 7 angespritzt, die dazu dienen, dass ein SMD-Bestückungsautomat das Batteriekontaktmodul in eine Leiterplatte einstecken kann, so dass es während des Reflow-Lötprozesses die Position nicht ändert. Durch diese zusätzliche Orientierungshilfe kann das Modul direkt über "Pick an Place" auf die Leiterplatte assembliert werden.

An den Rahmen 1 ist außerdem ein Montageelement mit einer Bohrung 8 angespritzt, mit dem das Batteriekontaktmodul 10 an einem Gehäuse eines Hörgeräts befestigt werden kann.

FIG 2 zeigt das Batteriekontaktmodul von FIG 1 in der Rückseitenansicht, wobei es auch in seine Montageposition gedreht ist, in der die Führungspins 6, 7 und die SMD-Kontaktpads 4, 5 unten angeordnet sind.

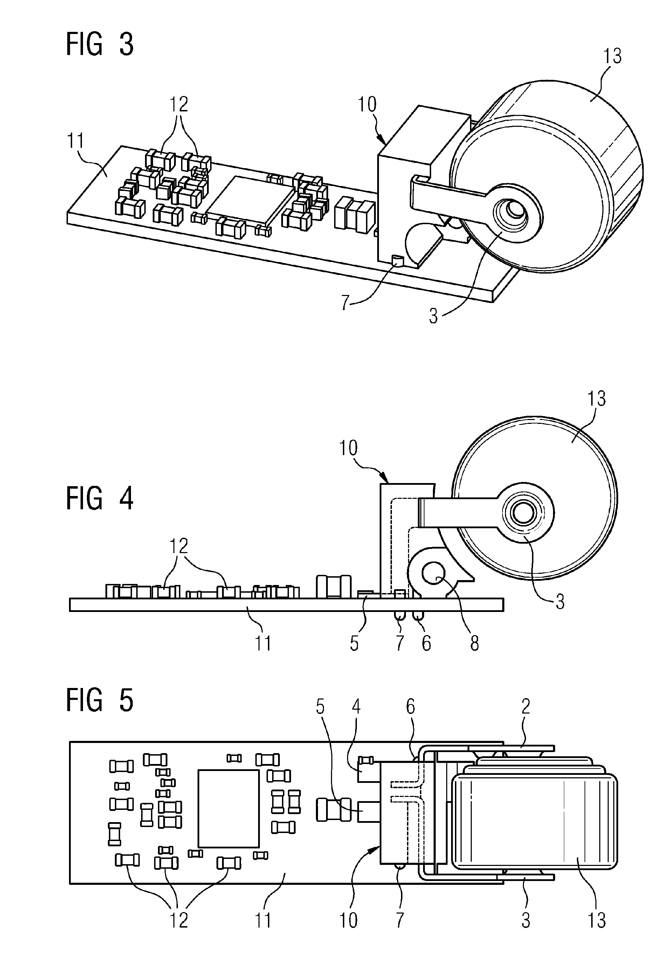

In FIG 3 ist das Batteriekontaktmodul 10 auf einer Leiterplatte 11 aufgelötet dargestellt. Die Leiterplatte ist weiterhin mit zahlreichen SMD-Bauteilen 12 bestückt. In die Kontaktfedern 2, 3 des Batteriekontaktmoduls 10 ist eine Batterie 13 eingespannt. Die Führungsstifte 6, 7 des Batteriekontaktmoduls 10 ragen durch entsprechende Bohrungen in der Leiterplatte 11.

Der gesamte in FIG 3 wiedergegebene Aufbau stellt die Verstärkereinheit eines Hörgeräts dar und ist in FIG 4 in der Seitenansicht zu sehen. In dieser Perspektive sind die Führungsstifte 6, 7 gut zu erkennen, wie sie die Leiterplatte 11 durchdringen, so dass diese lateral für den Lötprozess fixiert ist. Darüber hinaus ist in dieser Darstellung die Bohrung 8 gut zu erkennen, mit der sich das Batteriekontaktmodul 10 an einem Hörgerätegehäuse befestigen lässt. Sobald die Leiterplatte mit dem Batteriekontaktmodul 10 verlötet ist, dient die Bohrung 8 indirekt auch zur Fixierung der Leiterplatte 11 in dem Hörgerätegehäuse.

Die Draufsicht von FIG 5 auf die Verstärkereinheit zeigt insbesondere auch die SMD-Kontaktpads 4, 5, mit denen das Batteriekontaktmodul 10 auf die Leiterplatte 11 gelötet wird. Für das Reflow-Löten sind die SMD-Kontaktpads 4, 5 oberflächenbündig mit der Leiterplatte 11 ausgerichtet.

Damit das Batteriekontaktmodul den Reflow-Lötprozess unbeschadet übersteht, besteht der Kunststoffrahmen 1 aus einem spritzfähigen Kunststoff, der im ausgehärteten Zustand kein Wasser aufnimmt, d. h. nicht hygroskopisch ist. Würde sich nämlich in dem Kunststoff Wasser befinden, wie dies beispielsweise bei porösen Materialien der Fall sein kann, so würde er bei den hohen Temperaturen im Reflowofen bersten. Um diesbezügliche Beschädigungen zu vermeiden, wird der Kunststoffrahmen 1 vorzugsweise aus einem Flüssigkristallpolymer (LCP) gespritzt, das im erstarrten Zustand keinen Wasserdampf aufnimmt. Darüber hinaus besitzt das Flüssigkristallpolymer des Kunststoffrahmens 1 die Eigenschaft, dass es für zwei bis drei Sekunden der Reflowofentemperatur von bis 260 °C ausgesetzt werden kann, ohne dass es zu Verformungen kommt.

Durch das verwendete Batteriekontaktelement müssen keine Batteriekontakte mehr von Hand in einem Rahmen platziert werden, so dass Montagezeit eingespart werden kann. Außerdem lässt sich die Bestückung einer Verstärkerplatine für ein Hörgerät mit diesem Batteriekontaktmodul durch eine SMD-Maschine automatisch durchführen.

Ein weiterer Vorteil des SMD-Batteriekontaktmoduls besteht darin, dass auf der Leiterplatte keine Durchgangsbohrungen für die einzelnen Batteriekontakte vorgesehen sein müssen. Damit ist sowohl eine beidseitige Bestückung der Leiterplatte möglich als auch eine Verbesserung des Designs der Leiterplatte und damit eine Reduzierung ihrer Größe. Außerdem kann durch das SMD-Batteriekontaktmodul auf eine spezielle Fertigungsaufnahme verzichtet werden, welche zur Vormontage des Verstärkers benutzt wird. Der Vollständigkeit halber sei schließlich noch erwähnt, dass das manuelle Anlöten der Batteriekontakte mit dem erfindungsgemäßen SMD-Batteriekontaktmodul nicht mehr notwendig ist, wodurch sich auch Fertigungszeit einsparen lässt.

## Patentansprüche

1. Batteriekontaktmodul (10) für eine Hörvorrichtung mit
- einer elektrischen Kontakteinrichtung (2, 3, 4, 5) und
- einem Kunststoffrahmen (1), an/in dem die Kontakteinrichtung befestigt ist,
**dadurch gekennzeichnet, dass**
- das Batteriekontaktmodul (10) als SMD-Bauteil ausgebildet ist und die Kontakteinrichtung entsprechende Anschlüsse für eine Oberflächenmontage aufweist,
- der Kunststoffrahmen (1) eine Bohrung (8) oder ein vorspringendes Montageelement aufweist, mit der/dem das Batteriekontaktmodul (10) an einem Gehäuse der Hörvorrichtung befestigbar ist, und
- der Kunststoffrahmen (1) mindestens einen Führungsstift (6, 7) oder eine Führungsbohrung aufweist, um das Batteriekontaktmodul auf einer Leiterplatte (11) bei der Fertigung zu fixieren.

2. Batteriekontaktmodul nach Anspruch 1, wobei das Material des Kunststoffrahmens (1) zumindest an seiner Oberfläche nicht hygroskopisch ist.

3. Batteriekontaktmodul nach Anspruch 1 oder 2, wobei der Kunststoffrahmen (1) derart temperaturbeständig ist, dass er ohne Verformung für mindestens zwei Sekunden einer Temperatur von mindestens 250° C ausgesetzt werden kann.

4. Batteriekontaktmodul nach Anspruch 3, wobei es sich bei dem Kunststoff des Kunststoffrahmens (1) um ein Flüssigkristallpolymer handelt.

5. Batteriekontaktmodul nach einem der vorhergehenden Ansprüche, wobei die Kontakteinrichtung (2, 3, 4, 5) in den Kunststoffrahmen (1) eingespritzt ist.

6. Batteriekontaktmodul nach einem der vorhergehenden Ansprüche, wobei die Kontakteinrichtung (2, 3, 4, 5) zwei Metallfedern aus nicht rostendem Stahl aufweist.

7. Batteriekontaktmodul nach einem der vorhergehenden Ansprüche, wobei der Kunststoffrahmen (1) eine Bohrung (8) oder ein vorspringendes Montageelement aufweist, mit der/dem das Batteriekontaktmodul (10) an einem Gehäuse der Hörvorrichtung befestigbar ist.

8. Batteriekontaktmodul nach einem der vorhergehenden Ansprüche, wobei der Kunststoffrahmen (1) mindestens einen Führungsstift (6, 7) oder eine Führungsbohrung aufweist, um das Batteriekontaktmodul auf einer Leiterplatte (11) bei der Fertigung zu fixieren.
